# EUROPEAN PATENT SPECIFICATION

(11) **EP 0 344 008 B1**
(45) Date of publication and mention of the grant of the patent: **17.08.1994**
(21) Application number: 89305351.2
(22) Date of filing: 26.05.1989
(51) Int. Cl.: H01L 41/08

(54) **Vibrator-type actuator**
Antriebsanordnung vom Schwingungstyp
Organe d'actionnement de type vibrant

(30) Priority: 26.05.1988 JP 129122/88; 24.06.1988 JP 157506/88; 25.06.1988 JP 157712/88; 16.09.1988 JP 231726/88; 16.09.1988 JP 231727/88; 09.12.1988 JP 311453/88
(43) Date of publication of application: 29.11.1989
(73) Proprietor: Toda, Kohji, Yokosuka (JP)
(72) Inventor: Toda, Kohji, Yokosuka (JP)
(74) Representative: Woodward, John Calvin

(56) References cited:
- EP-A- 0 301 430
- US-A- 4 019 073

## Description

The present invention relates to a vibration-type actuator and more particularly to vibration-type actuator of simple construction using a piezoelectric vibrator as the electromechanical conversion means.

The vibration-type actuator using a piezoelectric vibrator as the electromechanical conversion means has been specifically developed for applications where small-sized and high-torque producing means are needed in precision mechanical equipment such as automatic focusing cameras, printers, copy machines and video cassette recorders, card transferring means in card identifying apparatus in banks, or object transferring means incorporated in an industrial robot FMS (Flexible Manufacturing System).

Ultrasonic motors have been used as vibration-type actuators. Ultrasonic motors are, generally, classified into three kinds. The first is a so-called "travellingwave-type" or "mode rotation-type"; the second, a "standing wave-type" based upon the standing wave; and the third a "multiresonance-type". The typical structure and operational principle of these motors are disclosed in the following papers:
"Ultrasonic Motors Using Piezoelectric Multi-Mode Vibrators" by TAKEHIRO TANAKA et al., JAPANESE JOURNAL OF APPLIED PHYSICS, VOL.27 (1988) SUPPLEMENT 27-1, PP.192-194,
"A Piezoelectric Ultrasonic Motor" by AKIO KUMADA, JAPANESE JOURNAL OF APPLIED PHYSICS, VOL.24 (1985), SUPPLEMENT 24-2, PP.739-741, and
"Construction of Ultrasonic Motors and their Application" by YOSHIRO TOMIKAWA et al., JAPANESE JOURNAL OF APPLIED PHYSICS, VOL.27 (1988) SUPPLEMENT 27-1, pp.195-197. However, the conventionally known ultrasonic motors are complex in both mechanical structure and circuit structure of the driving circuit for the piezoelectric vibrator, causing problems in miniaturization and cost reduction.

A paper feed apparatus which smoothly feeds paper to a predetermined position has been used in copying machines, facsimile machines, printers and the like. In this conventional paper feed machine, the paper is held between two rollers and is fed by rotating at least one roller by means of the electromagnetic motor. However, the electromagnetic motor is complex in structure and requires a speed reduction mechanism since it produces an extremely small torque at a low rotation speed. Thus, the conventional paper feed apparatus suffers from the disadvantages of being complex, large in size and expensive to manufacture.

Furthermore, in the FMS a workpiece to be manufactured is linearly moved or transferred by gears which convert the mechanical rotational movement produced by the electromagnetic motor into a linear movement. Such conventional work moving apparatus necessitates the use of an electromagnetic motor and gears and is therefore complex in structure and large in size. The movement of the workpiece along a curved rail has also been widely employed in various automatic machines such as industrial robots as well as FMS. However, they use an electromagnetic motor and gears which means that they suffer from the same disadvantages as those of the FMS. The ultrasonic motor can be used as an actuator which converts the electrical energy into the mechanical energy. An ultrasonic motor has superior characteristics to an electromagnetic motor in that it produces a larger torque at a lower rotational speed than an electromagnetic motor of the same size. However, the conventional ultrasonic motor requires a complex mechanical structure and driving circuit for the piezoelectric vibrator as stated before. As a result, miniaturization and cost reduction are difficult. EP-A-0301430 discloses according to Article 54(3) EPC a vibration type actuator comprising a ring shaped piezoelectric body and a moving element in contact with the base surface or the side surface of said body, the moving element being moved thereby on energisation of the body.

The present invention is characterised in that the piezoelectric body is pillar shaped having opposed base surfaces with electrodes thereon to receive a voltage for energising the body, the moving element contacting the piezoelectric body at a predetermined side surface portion thereof in such a manner that the generated driving force is directed parallel to the longitudinal axis of the body.

The piezoelectric body can be cylindrical in shape, square, pole, cube or pillar shaped.

Preferably, the side surface of the piezoelectric body is a plane surface extending in the longitudinal direction thereof.

A drive circuit is preferably connected to the electrodes for energising the piezoelectric body.

In another embodiment, a second said piezoelectric body is arranged to cooperate with and drive the moving element.

In one embodiment, the moving element is a rotary disk. Alternatively, it can be a guide rail.

In another embodiment, the moving element comprises a roller in contact with the side surface of the piezoelectric body in the longitudinal direction and rotated circumferentially due to the driving of said piezoelectric vibrator; supporting means maintaining the distance between the rotational axis of said roller and the piezoelectric body to provide a stable contact pressure between said roller and the piezoelectric vibrator; and a pressing means for pressing the roller against a piece of paper.

In yet another embodiment, the piezoelectric body comprises a square pillar with opposed ends with electrodes thereon, the moving element contacting the body at a predetermined contact pressure and on a side surface portion which is normal to the electrodes. At least one of the electrodes can be electrically separated into two electrodes.

Preferably, the pillar shape piezoelectric body is polarized and at least one of the electrodes is formed on a part of one base surface.

The vibration actuator of the invention provides a simplified mechanical structure for the piezoelectric vibrator which gives high reliability.

The preferred vibration actuators have a simplified driving circuit and are capable of low power consumption, a high speed operation and a large torque production.

An advantage of the vibration actuator of the invention is that it is capable of being used to arbitrarily control the vibration direction of the vibrator, or the moving direction of the moving element.

If desired, at least one of the paired electrodes of the piezoelectric body may be electrically separated into two electrodes.

Preferred embodiments of the invention will now be described, by way of example only, with reference to the accompanying drawings, in which:
Figures 1A and 1B are a sectional plan view and a plan view of one embodiment of the present invention;
Figure 2 is a table showing the coupling resonance frequencies of the vibrator of Figures 1A and 1B;
Figures 3A-3D, 4A-4C and 5A-5C show diagrammatically the displacements on the side surfaces of cylindrical vibrators having various lengths in the axial direction;
Figures 6A-6C are a plan view, a front view and a side view of another embodiment of the present invention;
Figure 7 is yet another embodiment of the present invention;
Figures 8A-8E show diagrammatically the displacements on the respective portions of a modified cylindrical vibrator of the present invention;
Figure 9 is a graph showing the relationship between the input voltage and the rotor rotational speed of the embodiment shown in Figure 1;
Figure 10 is a graph showing the relationship between the input voltage and the stop torque necessary for stopping the rotor in the embodiment of Figure 1;
Figure 11 shows exemplified waveforms of the pulsed intermitted rf burst alternative voltage;
Figures 12A and 12B respectively show a sectional plan view and a plan view of yet another embodiment of the present invention;
Figures 13A-13C show modified examples of the embodiments shown in Figures 12A and 12B;
Figures 14A-14C show an alternative shape of vibrator which can be used with the present invention;
Figure 15 is a perspective view of a paper feed apparatus embodying the present invention;
Figure 16 is a graph showing the paper feed speed characteristics of the embodiment shown in Figure 15;
Figure 17 is a perspective view of a still further embodiment of the present invention;
Figure 18 shows diagrammatically the vibration displacement of the piezoelectric vibrator in the embodiment shown in Figure 17;
Figure 19 is a graph showing the relationship between the frequency and the admittance of the piezoelectric vibrator in the embodiment shown in Figure 17;
Figure 20 is a perspective view of the embodiment shown in Figure 17;
Figures 21A and 21B show diagrammatically the vibration displacements of the piezoelectric vibrator at two resonance frequencies shown in Figure 20;
Figure 22 is a graph showing the relationship between the frequency and the admittance of the piezoelectric vibrator in the embodiment shown in Figure 20;
Figure 23 is a graph showing the relationship between the applied voltage and the rotor rotational speed in the embodiment shown in Figure 20;
Figures 24A and 24B are a side sectional plan view and a partially cut-off side sectional plan view of a moving apparatus for use with the present invention;
Figure 25 shows a piezoelectric vibrator and driving circuit for use in the present invention;
Figures 26A-26C show diagrammatically the vibration modes appearing on the cylindrical side of the piezoelectric vibrator of Figure 25;
Figure 27 shows diagrammatically the distribution of the vibration displacement on the cylindrical side surface of the piezoelectric vibrator shown in Figure 25;
Figure 28 is a graph showing the relationship between the applied voltage and the moving speed of the piezoelectric vibrator in the embodiment shown in Figures 24A and 24B;
Figure 29 is a side sectional plan view of a modified version of the embodiment shown in Figures 24A and 24B; and
Figure 30 shows diagrammatically the vibration displacement appearing on the cylindrical sides of the embodiment shown in Figure 29.

A pillar-shaped ceramic is employed as the piezoelectric vibrator in the present invention.
The principle of the vibration which occurs on the cylindrical vibrator will now be described.
It has been reported that the vibration of the cylindrical vibrator is assumed to be two-dimensional coupling of the longitudinal vibration and the radial vibration. The resonance angular frequency ω_{ℓ} in the longitudinal direction is expressed by: 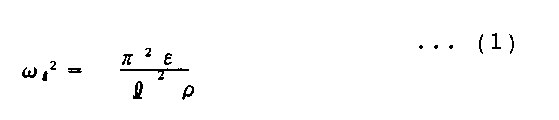
where ℓ is a length of the cylindrical vibrator; ρ , a density; and E, Young's modulus.
The resonance angular frequency ωᵣ in the radial direction ωᵣ is given by: 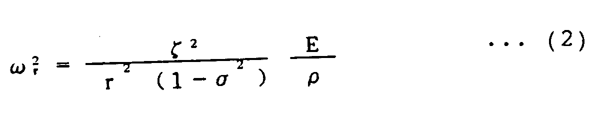
where r represents a radius of the cylindrical vibrator; σ , a Poison's ratio; and ζ , a root of the following Bessel function.

$\text{ζ J₀ (ζ) - (1 - σ) J₁ (ζ) = 0 (3)}$

In general, the resonance angular frequency of the isotropic vibrator is provided by the following formula; 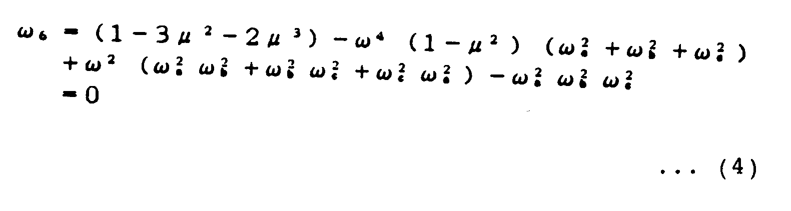
A basic formula of the three-dimensional coupling vibration of the cylindrical vibrator is obtained using the relations,

${\text{ω}}_{\text{a}} {\text{= ω}}_{\text{ℓ}}$
${\text{ω}}_{\text{b}} {\text{= ω}}_{\text{r}}$
${\text{ω}}_{\text{c}} {\text{= ω}}_{\text{r}} \text{(5)}$

as; 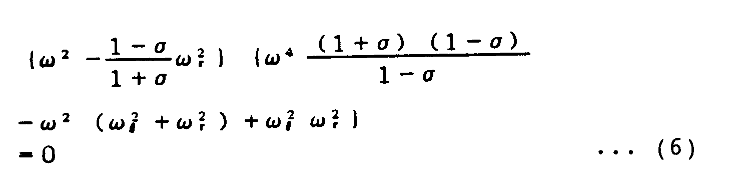
Using the following relation 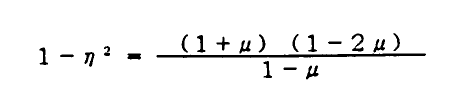
the second term of the equation (6) is presented as: 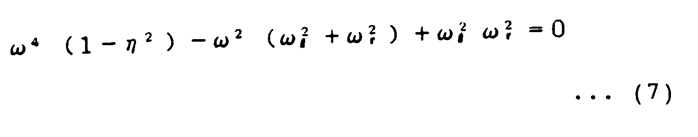
which obviously coincides with the two-dimensional coupling equation of ω_{ℓ} and ωᵣ having the coupling coefficient η . When the piezoelectric ceramic polarized in the longitudinal direction is driven, the vibration derived from the first term: 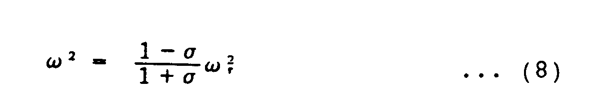
is not observed.

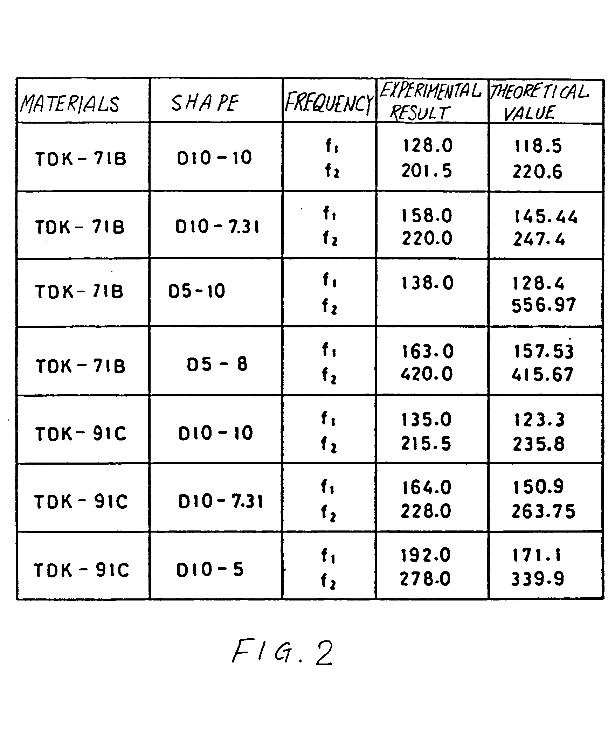

Figure 2 shows the experimental and theoretical first and second resonance frequencies f1 and f2 for the different materials and different shape parameters. As the materials models TDK 71B and TDK 91C (71B and 91C piezoelectric ceramic produced by TDK of Japan) were used. The shape parameters are a diameter and a length, for example, in Figure 2, D10-7.31 indicates that the diameter and longitudinal length are 10mm and 7.31mm, respectively. As seen from this drawing, the experimental and theoretical results on the coupling resonance angular frequencies of the cylindrical vibrator are well coincident one another.

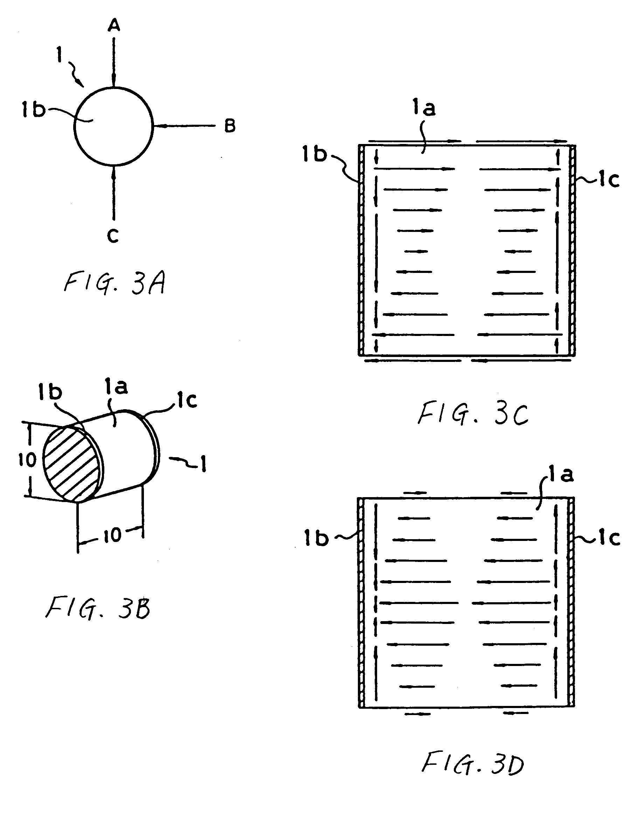

Responsive to the alternative voltage application of the above described coupling resonance frequency to the cylindrical-type vibrator polarized in the longitudinal direction, the vibration displacement is caused on the side surface of the vibrator. Figures 3A-3D schematically show the displacements on the side surfaces of the vibrator 1 when the alternative voltage of the first resonance angular frequency f1 is applied thereto. The cylindrical piezoelectric ceramic (TDK 91C) 1a is 10mm in diameter (D=2r) and 10mm in length and electrodes 1b and 1c are formed thereon. Here, it is to be noted that the thicknesses of the electrodes 1b and 1c are negligibly thin compared with the length of the piezoelectric ceramic.

Figure 3A is a side view of the cylindrical vibrator; Figure 3B, a perspective view of the vibrator; Figure 3C, a drawing indicating the vibration displacement on the side surface viewed in the direction of the arrow A; and Figure 3D, a drawing indicating the vibration displacement on the side viewed in the direction of the arrow B. In these drawings, the arrow direction on the surface of the piezoelectric ceramic 1a indicates the direction of the vibration displacement and the arrow length indicates the magnitude of the vibration displacement.

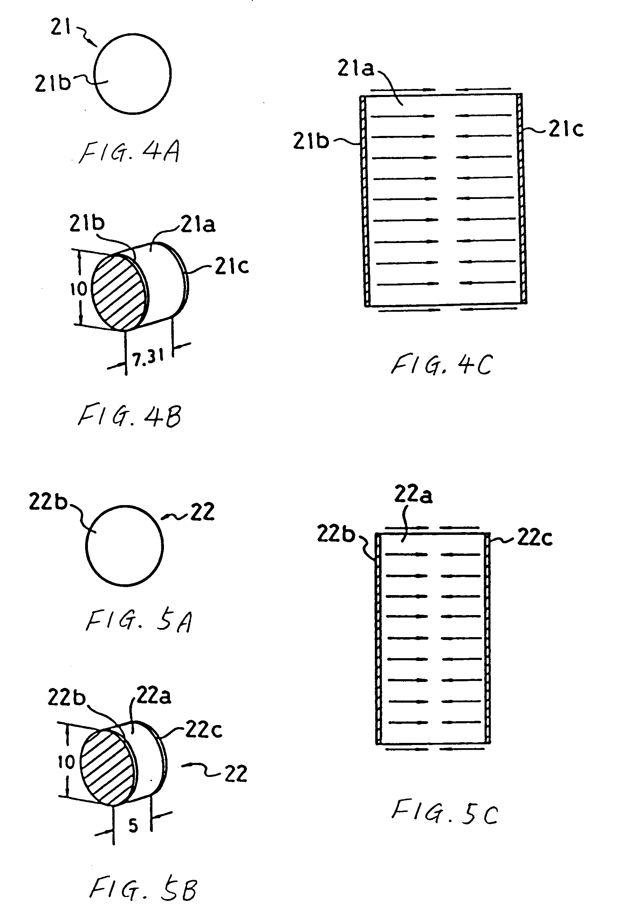

Figure 4A is a side view of the cylindrical piezoelectric vibrator comprising a cylindrical piezoelectric ceramic body 21 provided with electrodes 21b and 21c; Figure 4B, a perspective view of the vibrator 21; and Figure 4C, a drawing indicating the vibration displacement on the cylindrical side surface of the vibrator 21. Figures 5A-5C are the similar drawings to those of the foregoing where D=10mm and ℓ =5mm.

As is clearly understandable from Figure 3, the strong vibration displacement in one direction is produced in the vibrator having the same values as the diameter D and the length ℓ . The vibration displacement in the circumferential direction is small on the portion where the vibration displacement in the longitudinal direction is large, while the vibration displacement in the circumferential direction is large on the portion where the vibration displacement in the longitudinal direction is small.

The present invention provides various embodiments based on the foregoing characteristics of the cylindrical piezoelectric ceramic vibrator. More specifically, for example, the moving element is made in contact with the side surface where the longitudinal (axial) displacement is large in the cylindrical piezoelectric vibrator and the side surface where the longitudinal displacement is small is supported by the fixing portion, thereby realizing an effective actuator.

The roller contacts the surface portion of the large displacement of the piezoelectric body and also contacts the moving element to effectively convert the vibrational displacement of the vibrator into the rotational force for transferring the moving element. Thus, an effective actuator is made possible by making the contact between the roller and the vibrator at a point or a line contact situation.

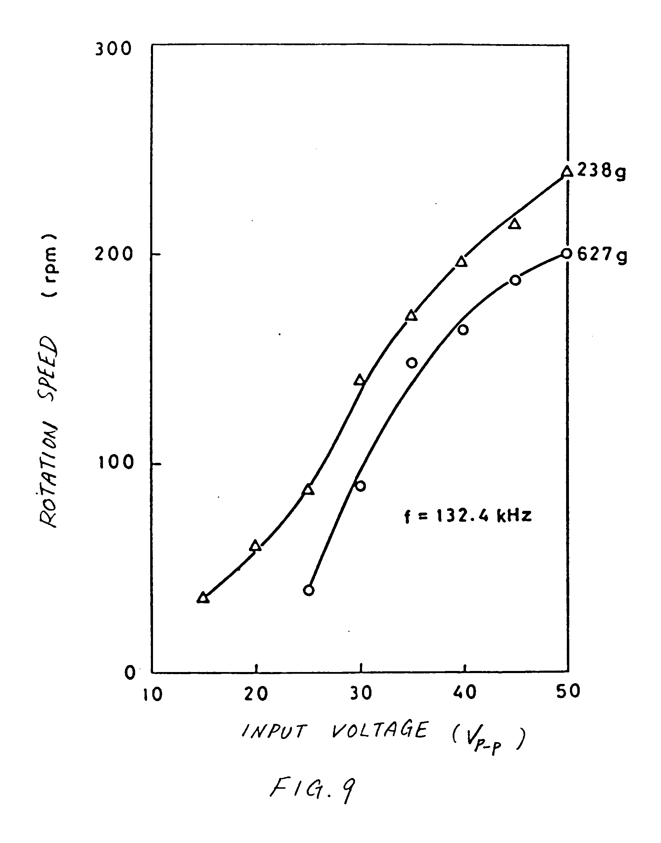

In Figures 8A-8E there are shown the structures and vibration situation of a cylindrical vibrator in which a part of the side surface is cut off to form a plane surface parallel to the longitudinal axis of the vibrator. Figure 8A is a side view of the vibration 23; Figure 8B a perspective view of the vibrator 23; and Figures 8C, 8D and 8E show diagrammatically the vibration displacements of the vibrator 23 when viewed in the direction of arrows A, B and C in Figure 8A respectively.

The vibrator 23 is the same as that shown in Figure 3 except that a part of the side surface has been cut off.

As can be seen clearly from Figure 8E, the longitudinal displacement is small on the flat surface formed by the cut off. Therefore, the vibrator may preferably be supported by the housing at the flat surface. The same displacement can also be seen on the two flat surface symmetrically formed with respect to the longitudinal direction.

The poling directions of the vibrator shown in Figures 3 to 5 and 8 are coincident with the longitudinal (length) direction of the vibrator (base line direction of the cylindrical piezoelectric body).

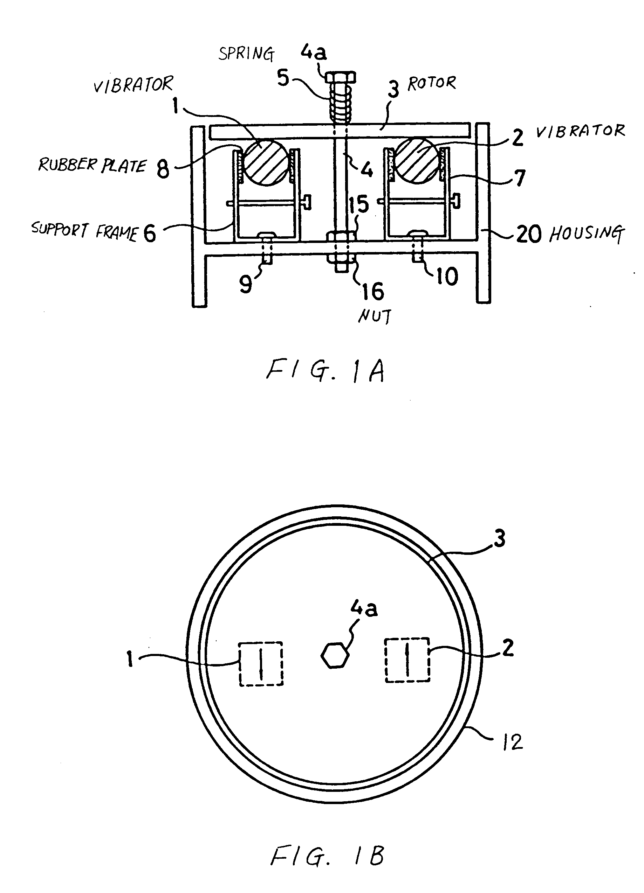

Figures 1A and 1B are a sectional view and a plan view of a first embodiment of the present invention.
The actuator in this embodiment comprises vibrators 1 and 2 operating as the stator, a rotor 3, an axis 4 round which the rotor 3 is supported and freely rotatable, a spring 5 pressing the rotor 3 against the vibrators 1 and 2 with a predetermined contact pressure, vibrator support frames 6 and 7 respectively supporting the vibrators 1 and 2 through the sponge rubber plate 8, a housing 20, bolts 9 and 10 for fixing the vibrator support frames 6 and 7 to the housing 20, and nuts 15 and 16 for fixing the axis 4 to the housing 20. The rotor 3, corresponding to the moving element, is driven by the vibrators 1 and 2 and is rotated round the axis 4.

The vibrators 1 and 2 are provided at positions having the same distances from the axis 4 or the rotation center of the rotor 3. The vibrators 1 and 2 make contact with the rotor 3 at the portion of the cylindrical side surface where the displacement in the longitudinal direction is at a maximum and with rubber plate 8 at the portion where the longitudinal displacement is at a minimum.

The vibrators 1 and 2 contact the rotor 3 such that the direction of the displacement on the contact portion with the rotor 3 is that shown in Figure 1B. For example, when the side surface of the vibrator 1 indicated by the arrow A in Figure 3A contacts with the rotor 3, the displacement directions of the vibrators 1 and 2 are as shown in Figure 1B, i.e. the surfaces of the vibrator 2 indicated by the arrow A or C shown in Figure 3A contact with the rotor 3. The spring 5 presses the rotor 3 against the vibrator 2 using head portion 4a of the axis 4 as the fulcrum. The pressure strength applied by the spring 5 is arbitrarily adjustable by loosening the nuts 15 and 16, moving the axis 4 upward or downward, and then tightening the nuts 15 and 16.

Figure 9 is a graph showing the relationship between the input voltage and the rotor rotational speed of the embodiment of Figure 1 where the rotor 3 is pressed against the vibrators 1 and 2 with contact pressures of 238g and 627g and an alternating voltage of 132.4kHz is applied to the vibrators 1 and 2. It was found that the rotor 3 was smoothly rotated at a high speed in this embodiment.

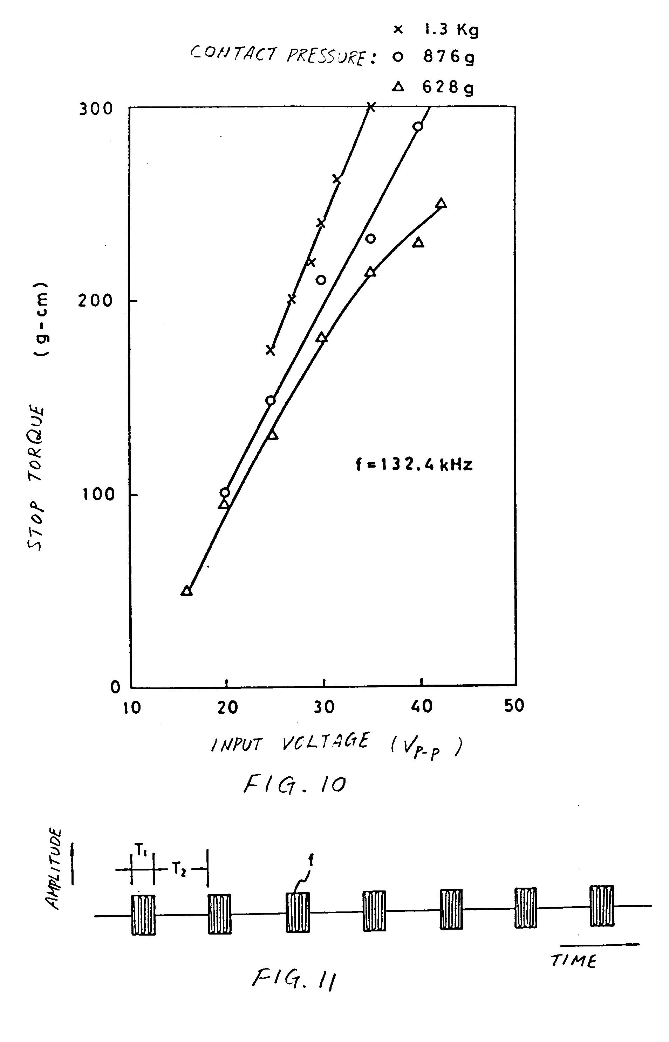

Figure 10 is a graph showing the relationship between the input voltage and the stop torque necessary for stopping the rotation with a parameter of the pressure strength of the rotor 3 in the embodiment of Figure 1. A relatively large stop torque of 300g cm is obtainable when the rotor 3 is pressed against the vibrators 1 and 2 with a pressure of 1.3kg and an input voltage of 35Vp-p.

In the embodiment of Figure 1, the rotor 3 is continuously rotated by applying two alternating voltages of a frequency f having opposite polarities to the vibrators 1 and 2.

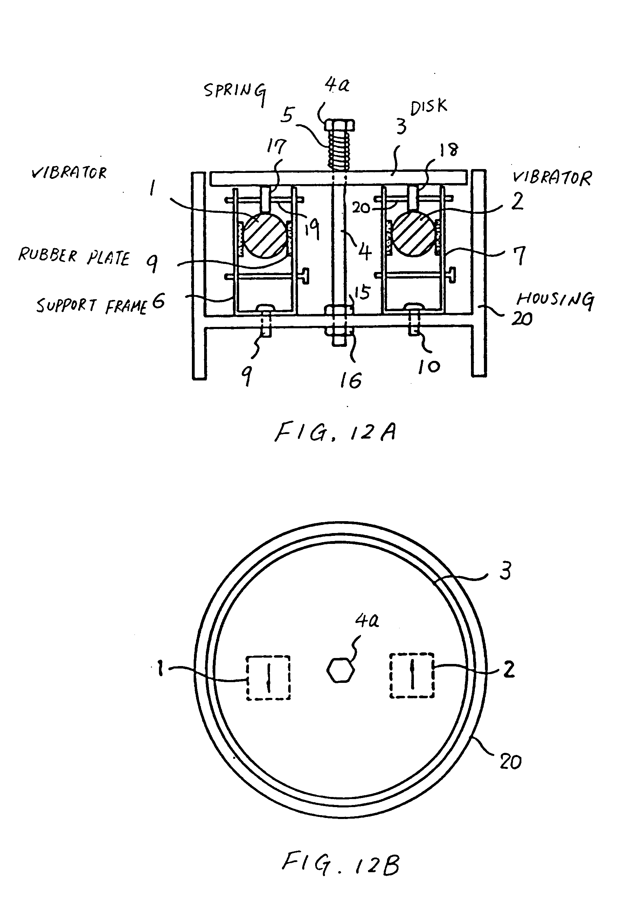

On the other hand, when the alternating voltage of a frequency f1 is applied during a time period T1 and not applied during the next time period T2 as shown in Figure 11, the rotor 3 is intermittently rotated. This means that the embodiment of Figure 1 may be operated as a stepping motor. The rotation angle of the rotor 3 is proportional to the number of the carrier wave of the alternating voltage in one pulse, i.e. to the time period T1 of one pulse.

It is to be noted that the present invention is also applicable to a structure in which the rotor 3 is fixed to the axis 4 which is supported and is freely rotatable by the housing 20. When the axis 4 is rotated together with the rotor 3, the axis 4 is preferably supported by the housing 20 through a bearing. Although the rotor 3 is pressed against the vibrators 1 and 2 by the spring 5, the spring is not necessarily required in the present invention. A concentric circular plane weight provided on the rotor 3 and a spring provided under the vibrators 1 and 2 for pressing them against the rotor 3 may be employed instead.

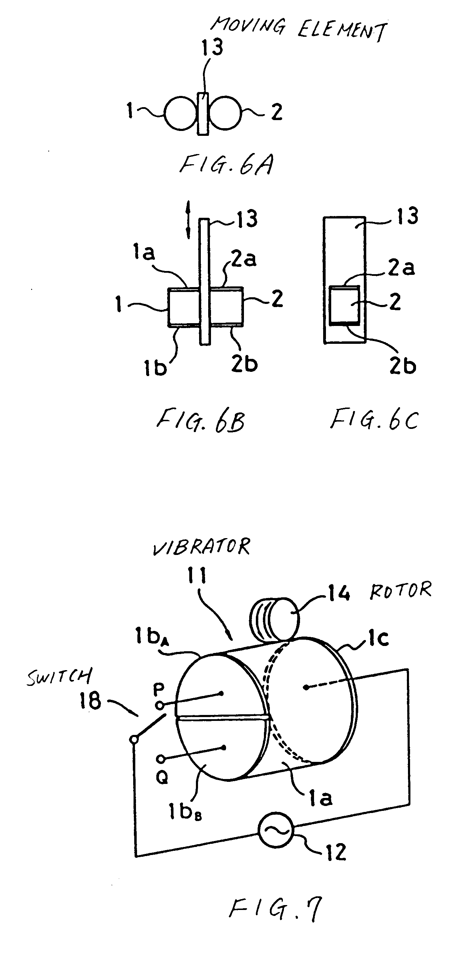

Figures 6A, 6B and 6C show a plan view, a front view and a side view of another embodiment of the present invention. In this embodiment, the moving element 13 is held between the vibrators 1 and 2. The moving element 13 is moved upwardly and downwardly in the direction of the arrow in Figure 6B by supplying an in-phase driving signal to the vibrators 1 and 2. This structure may produce a larger torque. To press the vibrators 1 and 2 against the moving element 13, an elastic material such as the spring shown in Figure 1 is used.

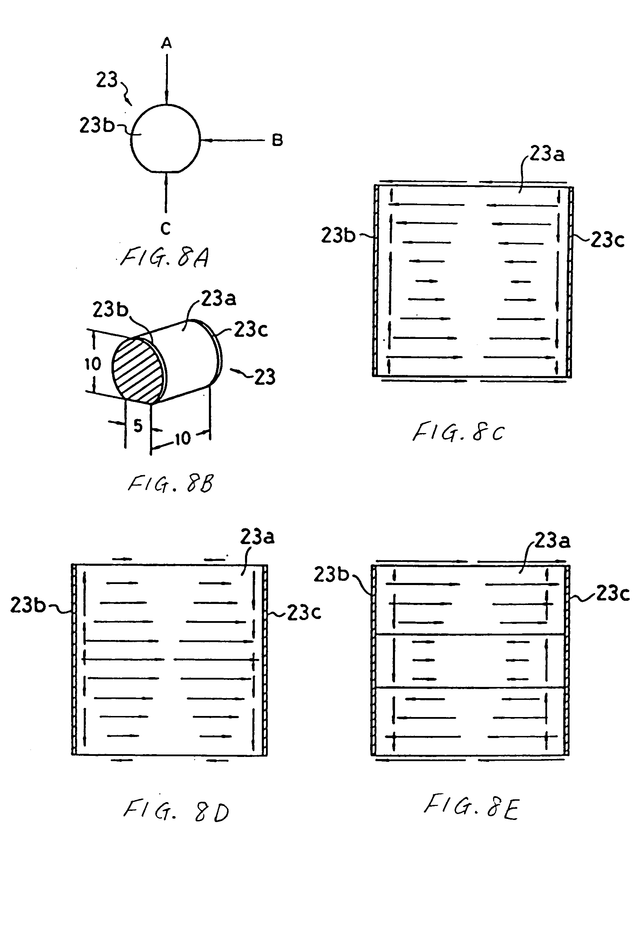

In Figure 7 there is shown a structure for arbitrarily controlling the vibration direction of the vibrator. In this embodiment, the electrode formed on one end surface of the vibrator is electrically separated into two electrodes 1b_{A} and 1b_{B}. The two electrodes are respectively provided with input terminals P and Q and the driving signal from an alternative power source 12 is supplied to the terminal P or Q through a switch 18. Accordingly, the displacement directions of the vibrator 11 are opposite for the applications of the ac voltage to the electrode 1b_{A} through the terminal P and to the electrode 1b_{B} through the terminal Q. The rotor 14 is pressed against the cylindrical side surface of the vibrator 11 and is rotated in the displacement direction of the vibrator 11 on the contact portion. As a result, the rotation direction of the rotor 14 is arbitrarily selectable by means of the switch 18. It should be noted here that one of the paired electrodes 1b_{A} and 1b_{B} may be removed or an electrode can be formed on a part of one end surface of the vibrator 11 to specify the surface of a large and a small vibration displacement. In other words, the vibration situation may be specified by the asymmetrical formation of the electrode.

As described above in detail, according to the present invention it is possible to provide a vibrator-type actuator having a simplified mechanical structure and driving circuit for the piezoelectric vibrator which is operable with a single-phase ac voltage.

Figures 12A and 12B show a sectional view and a plan view of other embodiments of the present invention. The structure of this embodiment is essentially the same as that in Figures 1A and 1B except that the rotational driving torque is transmitted to the disk (rotor) through rollers 17 and 18 rather than directly from the vibrator. The supply of the driving force to the vibrators 1 and 2 and the control of the rotational direction are the same way as that of Figure 1.

In the embodiment of Figures 13A-13C, moving element 25 is supported by vibrators 26 and 27 and the rotors 17 and 18 and the moving element 25 is moved in the direction of the arrow by exchanging the supply of the driving signal to the separated electrodes 26b_{A}, 26b_{B}, 27b_{A} and 27b_{B}.

In this embodiment, the roller contacts with the vibrator at a point-like area. Therefore, the direction of the vibration displacement of the vibrator at the contact portion is completely coincident with the rotational direction of the roller and there is little friction based upon the speed difference between the vibrator and the roller.

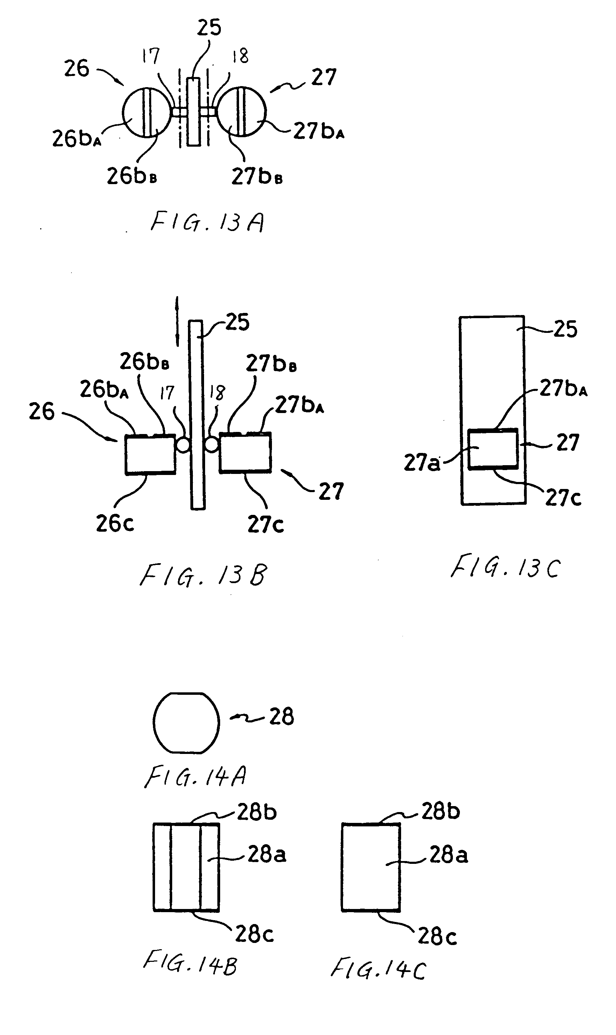

The present invention may employ the vibrator in which a small vibration displacement in the specified direction is produced only on a small area since the contact area between the vibrator and the roller is extremely small. For example, in the embodiment of Figure 13, the vibrator can be of a size the same as that in Figure 4 and the vibrator 22 can have a thickness of 5mm the same as that in Figure 5. Consequently, miniaturization using a vibrator-type actuator of the present invention becomes easier than the conventional vibrator.

In the above described embodiment, the roller makes direct contact with the piezoelectric body of the vibrator. A thin metal plate may be formed on the surface of the piezoelectric body for contact by the roller and the vibrator may contact the roller through the metal plate. Since the vibration displacement is caused even on the metal plate formed on a part of surface of the piezoelectric body, the roller may also be rotated in the same way as that without the metal plate and the abrasion of the piezoelectric body may be prevented.

Furthermore, the roller for converting the vibration displacement of the vibrator into a rotational movement contacts the vibrator at its outer end circumference and the rotational axis of the roller is parallel to the poling axis of the vibrator. Therefore, the contact area between the vibrator and the roller is extremely small and there is little difference in magnitude and direction between the two speeds at the contact surface, thereby reducing the abrasions of the vibrator and the roller. It is clearly understandable that the pillar-shape vibrator may be applied to the present invention.

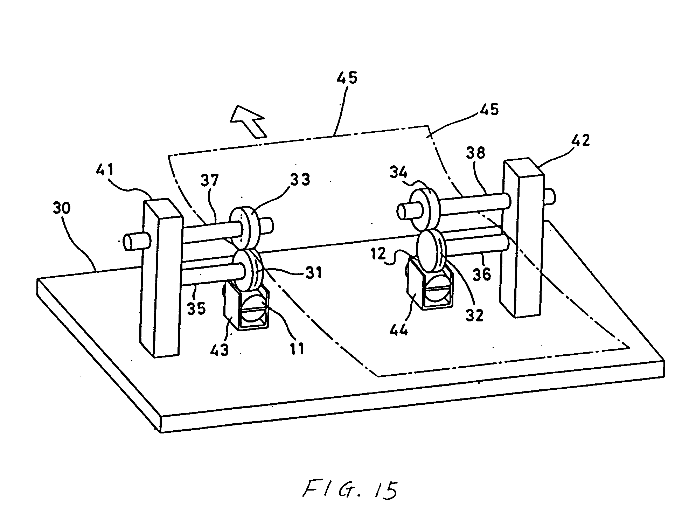

Figure 15 is a perspective view of a paper feed apparatus of the present invention comprising cylindrical piezoelectric vibrators 11,12, an aluminium table 30, metal rollers 31-34, axes 35-38, supporting poles 41,42 and vibrator supporting frames 43,44. The diameters of the cylindrical piezoelectric vibrators 11,12, the rollers 31,32 and rollers 33,34 are 10mm, 19mm and 23mm, respectively.

The supply of the driving signal to the vibrators 11 and 12 is by means of the system as shown in Figure 7. More specifically, one electrode of the paired electrodes of the vibrator 11 is electrically separated into two electrodes 1b_{A} and 1b_{B}. One terminal of the ac power source 12 is connected to the electrode 1C and another terminal thereof is exchangeably connected with the electrodes 1b_{A} and 1b_{B} through the switch 18. The vibration displacement on the vibrator 11 is reversed by moving the switch from the terminal P to Q or the terminal Q to P. The vibrator 12 has the same structure as the vibrator 11. The switches 18 of the vibrators 11,12 are synchronously controlled by one another. The supporting posts 41,42 and the vibrator supporting frames 43,44 are fixed to the table 30. The vibrator supporting frames 43,44 support the vibrators 11,12 by holding the portions thereof where the displacements are minimum. The axes 35,37 and 36,38 are fixed, respectively to the supporting posts 41 and 42. The rollers 31 and 32 rotate about the axes 35 and 37 through the bearings so as to be freely rotatable and the rollers 32 and 34 rotate about the axes 36 and 38 through the bearing so as to be freely rotatable.

The rollers 31 and 32 are pressed against the surface portion of the vibrators 11 and 12 where the displacement is at a maximum with a predetermined static pressure. When the alternating voltages are applied to the vibrators 11 and 12, the rollers 31 and 32 have a force applied thereto in a circumferential direction by the vibrators 11 and 12 and are rotated.

The gaps between the rollers 31 and 33 and the rollers 32 and 34 are slightly less than the thickness of the paper 45. Upon contact of front edge 45a of the paper 45 with the gap between the rollers 31 and 32 when moved in the direction of the arrow, the paper 45 is held by the rollers 31,33 and 32,34 and is then fed forwardly in the direction of the arrow.

The paper 45 suddenly stops when the switch 18 is exchanged to the neutral terminal N during feeding by supplying the ac voltage to the electrode 1b_{A} through the switch 18 and the terminal P. On the other hand, the paper 45 is fed in the reverse direction when the ac voltage is supplied to the electrode 1b_{B} through the terminal Q.

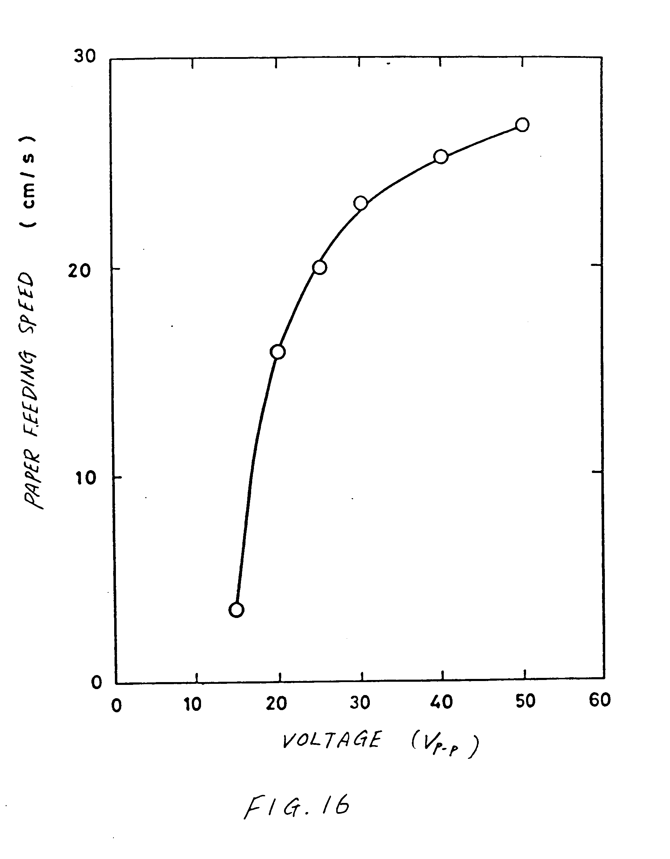

Figure 16 is a graph indicating the paper feed characteristics of the embodiment shown in Figure 15. It can be seen from this graph that the paper feeding speed may be controlled over a wide range by only changing the voltage applied to the vibrator. The paper may be fed forwardly and backwardly by using the piezoelectric vibrators 11 and 12 as the driving means without employing an electromagnetic motor, thereby simplifying the structure. This embodiment has substantial advantages in miniaturization and cost.

In the embodiment of Figure 15, the rollers 31 and 32 may be replaced with one wide cylinder. Namely, although two roller pairs (31,33 and 32,34) holding and feeding the paper 45 are used in the illustrated embodiment, one pair, three or more pairs of the wide cylinders may be used if each roller pair has a rotational force applied to it by the piezoelectric vibrator.

A separated vibrator as shown in Figure 3 is used in this embodiment. Since the piezoelectric vibrator contacts with the first roller (corresponding to roller 31 or 32) at a point or line-like area and the displacement is transmitted to the paper 45 through the first roller, the vibrators shown in Figures 4 and 5 having the opposite vibration displacement directions depending upon the portion may be used. Therefore, the present invention may use a small-sized vibrator.

The vibrator can be square, pole or pillar shaped as well as cylindrical as illustrated.

Furthermore, a thin metal plate may be formed on the surface of the piezoelectric body with which the first roller makes contact. Thus, the displacement is transmitted to the first roller through the thin metal plate thereby avoiding abrasion of the piezoelectric body.

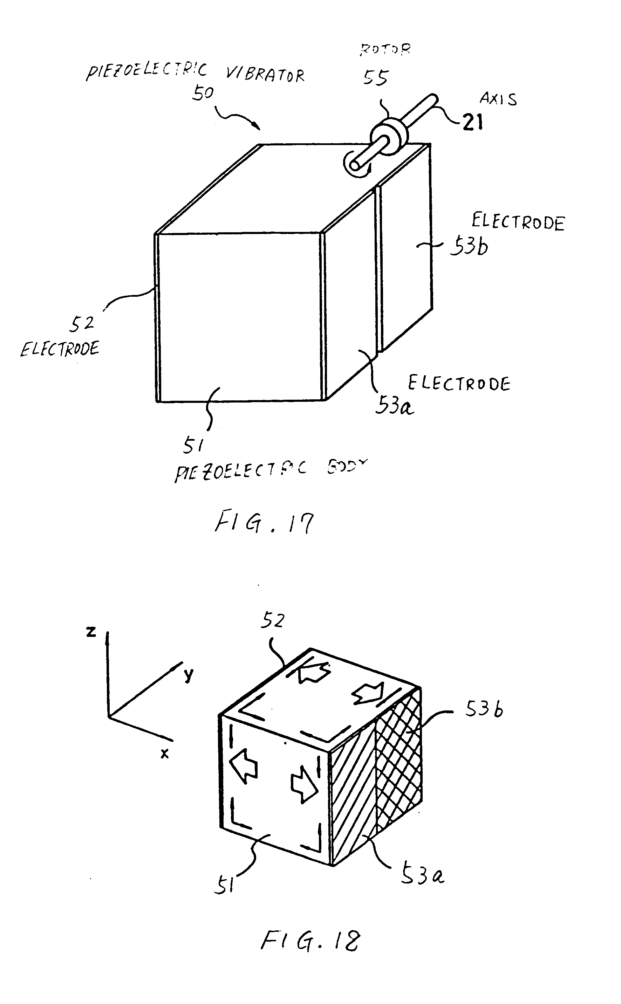

Figure 17 is a perspective view of another embodiment of the present invention using a square pillar-shaped piezoelectric vibrator.

This embodiment comprises a piezoelectric vibrator 50, a rotor 55 and pressing means (not shown) for pressing the rotor 55 against the piezoelectric vibrator 50. The piezoelectric vibrator 50 includes a ceramic piezoelectric body 51 and electrodes 52, 53a, 53b. The rotor 55 is provided with a rotational axis. The electrodes 53a and 53b are electrically isolated. The piezoelectric body 51 is cube shaped having one side line of 5mm. The material of the piezoelectric body 51 has a Young's modulus of:
Y$\frac{\text{E}}{\text{33}}$ = 7. 7 × 10¹⁰ (N/m²), a density ρ = 7. 6 × 10³ (kg/m²) and a Poisson's ratio of σ = 0.28. The poling axis of the piezoelectric body 51 is in the direction perpendicular to the electrodes 52, 53a and 53b. Figure 18 is a schematical drawing in which the arrows represent the vibration displacements on the surfaces of the piezoelectric body 51. The vibration displacements in the X and Y axes are produced in the opposite directions to those in Figure 18 when the alternating voltage is applied between the electrodes 52 and 53b. Here, the vibration displacement in the Y axis direction is still in the same direction as Figure 18 even if the electrode to which the voltage is applied is changed from the electrode 53a to the electrode 53b.

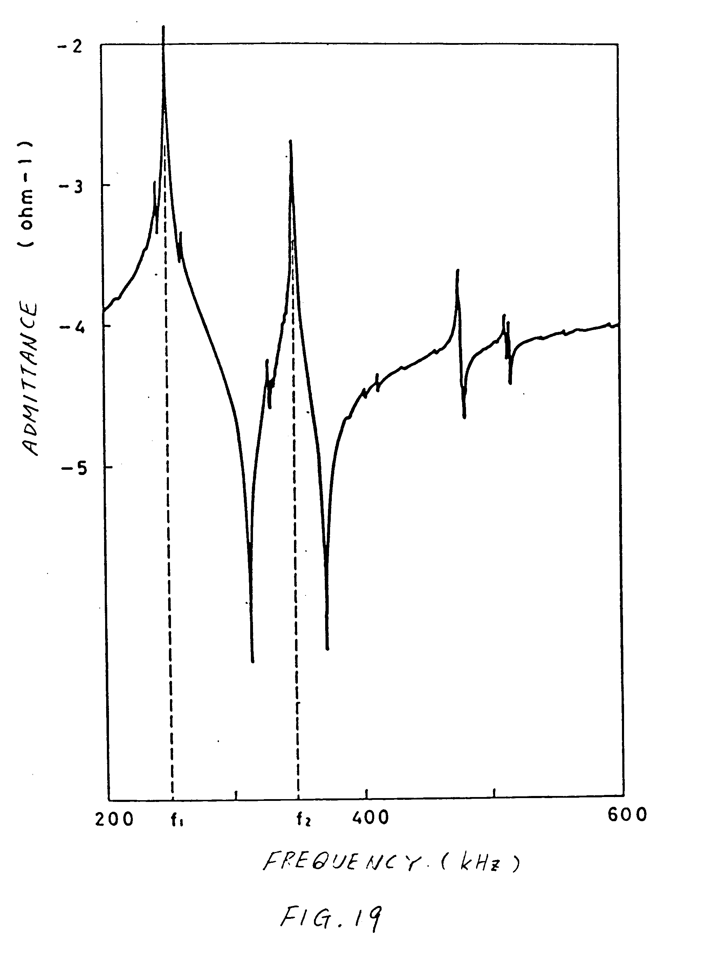

Figure 19 shows a frequency characteristic of the admittance of the piezoelectric vibrator when ac voltages of 200-600kHz are applied to the piezoelectric vibrator 50 in the embodiment of Figure 17. From this graph, it will be seen that the piezoelectric vibrator 50 resonates at frequencies f1, f2 and f3 where large vibration displacements appear. The f1 is 233.2kHz in this embodiment. The excitation of the piezoelectric vibrator 50 by this frequency causes the vibration displacements shown by the arrows in Figure 18.

The actuator in the embodiment of Figure 17 picks up the vibration displacement in Figure 18 as a rotational force so the rotor 55 is rotated round the rotational axis 54 in the direction of the arrow in Figure 17. The rotational direction of the rotor 55 may be controlled by changing the supply of the ac voltage from the electrode 53a to 53b.

In Figure 17, the rotor 55 is pressed against the piezoelectric body 51 at a stable pressure by well known means such as a spring.

This embodiment can be used with a cash dispenser in banks by pressing the rotor 55 against the card. The rotor 55 is preferably made of hard materials such as hard plastic or metal. However, hard materials can sometimes damage the card so in order to avoid such damages, a second rotor made of rubber can be used. The rotational force of the rotor 55 is transmitted to the second roller and the second roller is pressed against the card.

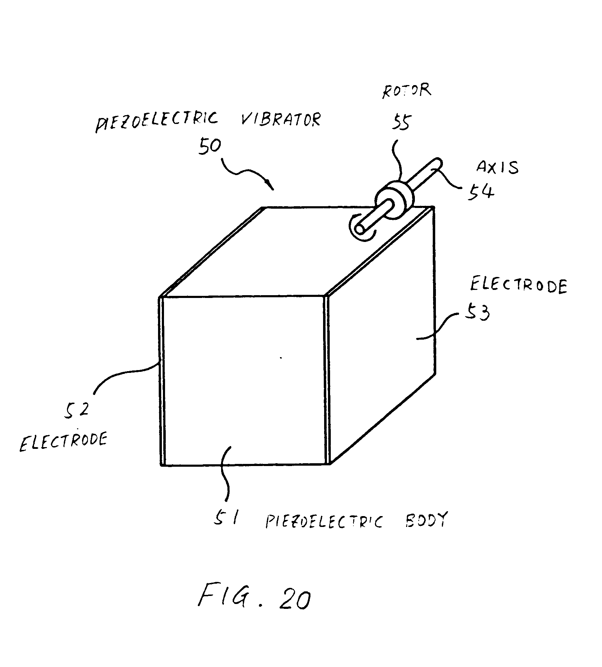

In this embodiment, the rotation direction of the rotor 55 may be arbitrarily controlled by exchanging the electrode to which a single-phase ac voltage is applied from 53a to 53b or 53b to 53a, thereby simplifying the driving circuit of the piezoelectric vibrator. Figure 20 shows an embodiment in which the electrodes 53a and 53b are not separated.

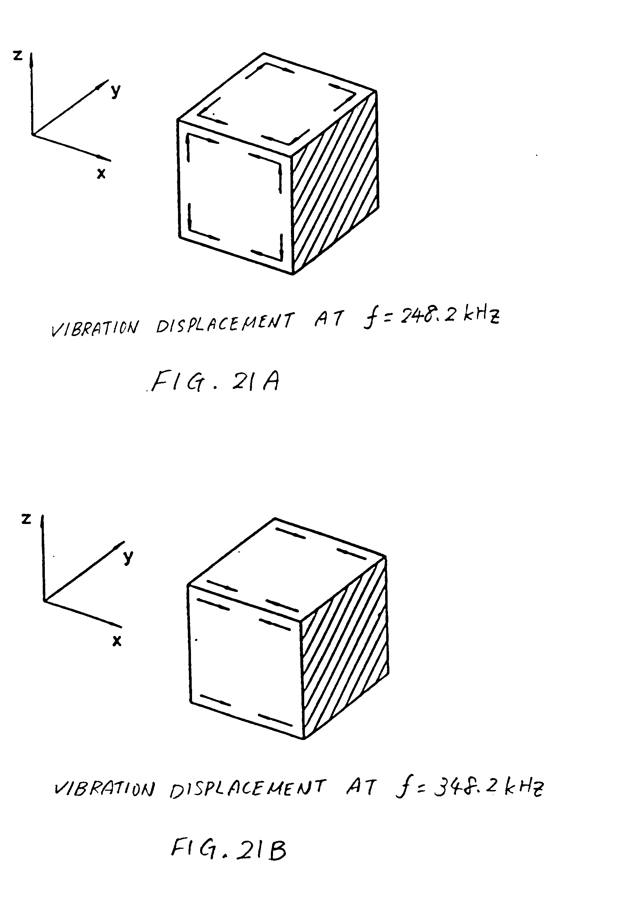

Figures 21A and 21B show the vibration displacements by arrows appearing on the surfaces of the piezoelectric body 51 when the ac voltages of frequencies 248.2kHz and 348.2kHz are applied between the electrodes 52 and 53 of the embodiment in Figure 1.

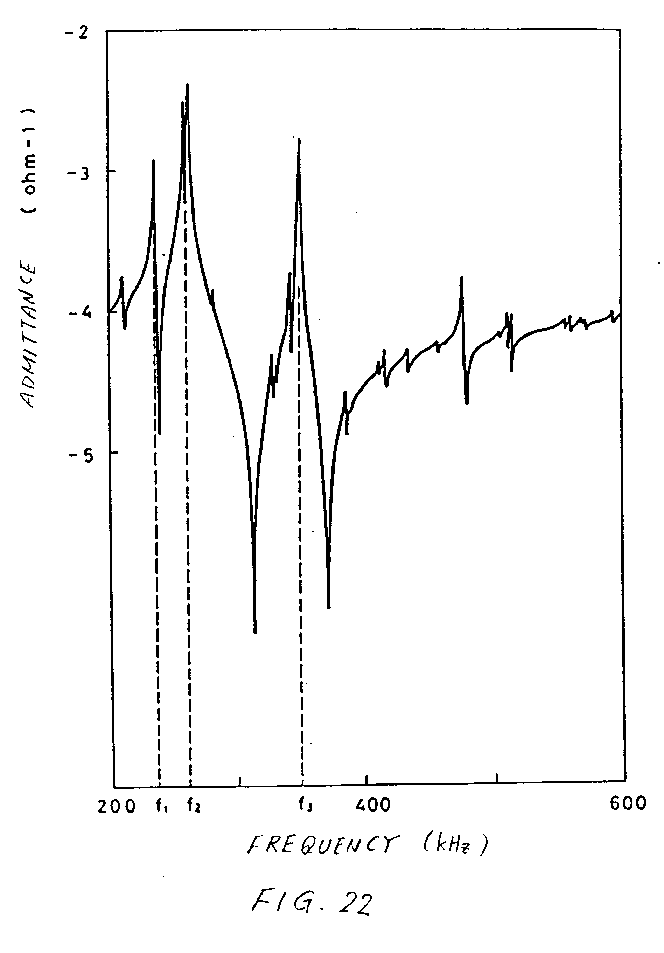

Figure 22 is a graph showing the frequency characteristic of the piezoelectric vibrator 50 in Figure 20 when ac voltages of frequencies of 200-600kHz are applied to it.

The piezoelectric vibrator 50 resonates at frequencies f1 and f2 and large vibration displacements appear thereon. The frequencies f1 and f2 are 248.2kHz and 348.2kHz, respectively. The excitation of the piezoelectric vibrator 1 by these frequencies cause the vibrator displacements indicated by the arrows in Figure 21, as described before.

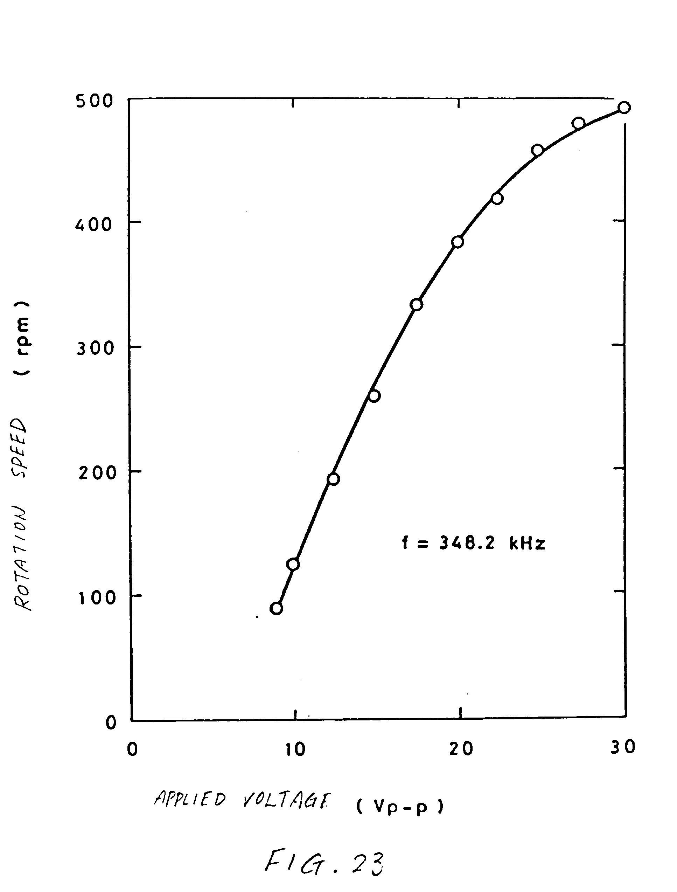

In the embodiment of Figure 20, the actuator picks up the vibration displacement shown in Figure 21 as a rotational force which rotates the rotor 55 round the rotational axis 54 in the direction of the arrow in Figure 20. In Figure 23, there is shown the relationship between the applied voltage and the rotational speed when an alternating voltage of a frequency of 348.2kHz is applied to the piezoelectric vibrator 50 of Figure 20. The graph indicates that the rotational speed of the rotor 55 may be controlled over a wide range.

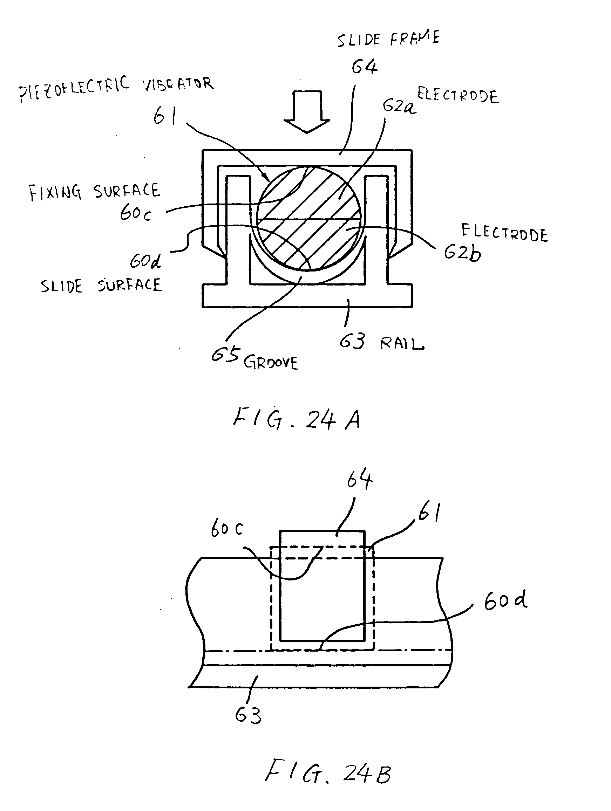

The next embodiment shown in Figures 24A and 24B is a moving apparatus which includes a piezoelectric vibrator guided by the rail.

In this embodiment the piezoelectric vibrator 61 is cylindrical in shape and produces a vibrational displacement on its side surface 60d which is pressed against the inner surface of a rail 63. The piezoelectric vibrator moves along the rail 63 based upon its reaction therewith. The moving direction is determined depending upon the applied voltage to the electrode of the piezoelectric vibrator.

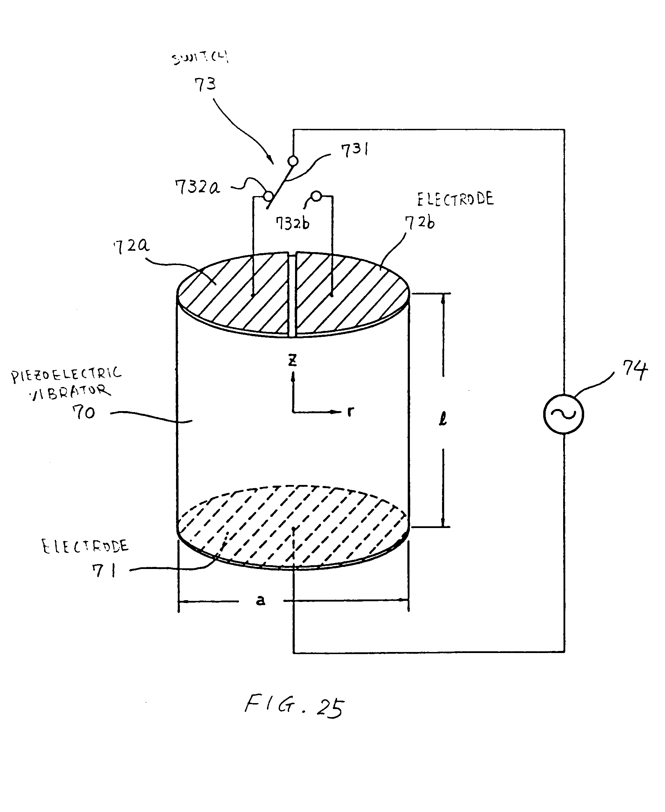

Figure 25 shows a piezoelectric vibrator 70 and an electric circuit for driving it using a single-phase ac voltage. The driving circuit comprises a switch 73 and a single-phase alternating power source 74. The piezoelectric vibrator 70 is cylindrical in shape and has electrodes 71,72a and 72b at each end thereof. The electrode 71 is formed on one end surface and the electrodes 72a and 72b are formed on the other end surface electrically separated by, for example, an etching technique. The switch 73 includes contacts 732a and 732b and alternately applies the ac voltage from the power source 74 to the electrode 72a or 72b.

Upon application of the ac voltage between the electrodes 71 and 72a (or 72b) for driving the piezoelectric vibrator 70, the wave motion or the vibration displacement appears on the side surface. The directions of the wave motions are axial (z direction) or radial (r direction).

Now, it is to be assumed that the phases of the wave motions in the z and r directions are opposite and the expansion in the z direction is caused when the compression is caused in the r direction. The displacements Uz and Ur at an arbitrarily selected mass point in the z and r directions are expressed as:

${\text{U}}_{\text{z}} {\text{= U}}_{\text{zo}} \text{· COS ωt (9)}$

${\text{U}}_{\text{r}} {\text{= U}}_{\text{ro}} \text{· COS (ωt-φ) (10)}$

where Uzo, Uro represent amplitudes of the displacements, and ω and φ represent an angular frequency and a phase difference between the vibration displacements in the z and r directions.
The displacement amplitudes in the cylindrical vibrator are expressed by:

${\text{U}}_{\text{zo}} {\text{= A sin (k}}_{\text{z}} \text{· Z)}$
${\text{U}}_{\text{ro}} {\text{= B J₁ (k}}_{\text{r}} \text{· r)}$

where
A,B : constants
k_{z}, kᵣ : wave numbers
J₁ : Bessel function of the first order.
When the phase φ is 90, the locus of the mass point is expressed by 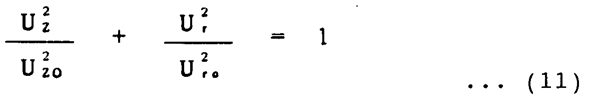
indicating elliptic motion. It is well-known that the locus of the mass point becomes elliptical.
In this embodiment, the ac voltage is applied to one of the separated electrodes 72a and 72b formed on the end surface of the cylindrical ceramic in an asymmetrical situation to determine the direction of the elliptical motion on the surface thereof.

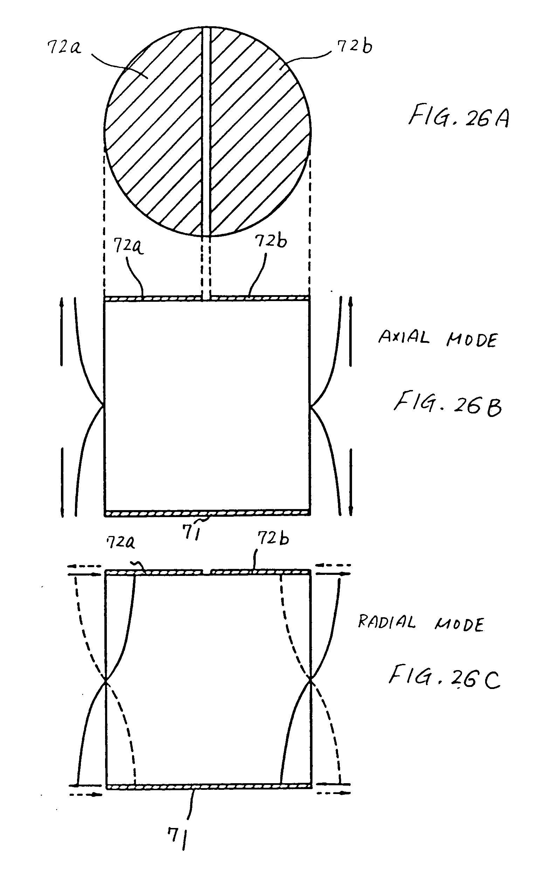

Figures 26A-26C show vibration modes appearing on the side surfaces of the piezoelectric vibrator 70 in Figure 25. Figure 26A is a side view of the piezoelectric vibrator 70 with the separated electrodes 72a and 72b; Figure 26B shows schematically the vibration mode in the axial direction; and Figure 26C shows schematically the vibration mode in the radial direction which is asymmetric with respect to the axial direction. In Figure 26C, the broken lines indicate the vibration modes when an ac voltage is applied to the electrode 12a and the solid lines indicate the vibration mode when the alternating voltage is applied to the electrode 72b. As described above, since the axial direction vibration (longitudinal vibration) and radial direction vibration are produced by the opposite phase signals, and the radial direction vibration is asymmetric with respect to the axis as shown in Figure 26C, it is possible to produce the wave moving only in one direction on each part of the cylindrical side surface of the piezoelectric vibrator 70. The directions of the displacements (wave directions) due to the elliptical motion on the axially symmetrical positions of the vibrator 70 are opposite one another. The direction of the vibration displacement may be reversed by changing the electrode to which the ac voltage is applied, i.e. by connecting the moving contact 731 with the fixed contact 732a or 732b.

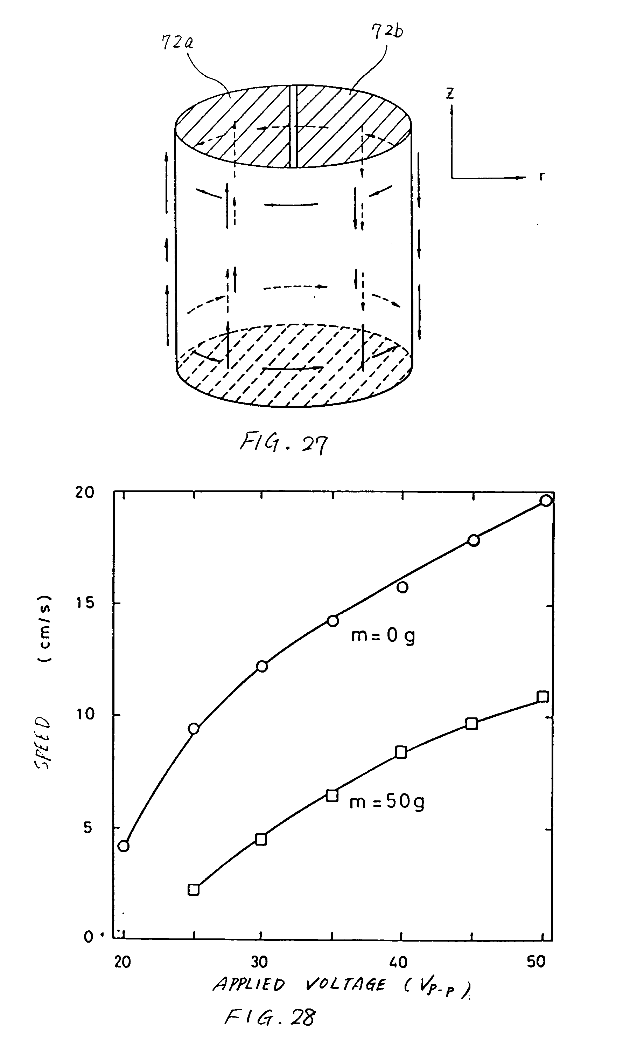

Figure 27 shows the distribution of the vibration displacement on the cylindrical side surface of the piezoelectric vibrator 70 in Figure 25. In the drawing, the length of the arrow corresponds to the amplitude of the displacement, the solid arrow indicating the vibration displacement on the front surface and the broken arrow indicating that on the back surface. The displacement in the circumference direction is small on the portion where the displacement in the axial direction is large, while the circumferential displacement is large on the portion where the axial displacement is small. For example, it will be seen that the displacement in the z direction exists only on the left end surface and the displacement in the -z direction exists only on the right end surface.

The embodiment presses the surface where a large vibration displacement appears in the z or -z direction of the piezoelectric vibrator against the rail, thereby moving the piezoelectric vibrator along the rail based upon its reaction. The direction of the vibration displacement, that is, the moving direction of the piezoelectric vibrator may also be reversed by the switch operation.

In Figures 24A and 24B, there are shown a lateral side sectional view and a partially cut-off side sectional view.

This embodiment comprises a piezoelectric vibrator 61, a rail 63 and a slide frame 64. AC voltage is supplied to the piezoelectric vibrator 61 from a single-phase ac power source 74 through switch 73. The piezoelectric vibrator 61 is moved along the fixed rail 63. The switch 73 is provided on a base surface (not shown) of the piezoelectric vibrator 70. The ac power source 74 applies the single-phase ac voltage between the switch 73 and the electrode 71 by means of a flexible wire. The piezoelectric vibrator 61 is fixed to the slide frame 64 at a fixing surface 60C and contacts the base of groove 65 of the rail 63 at a sliding surface 60d. The arbitrary movement of the piezoelectric vibrator 61 in the longitudinal direction is made possible due to the reaction from the base surface of the groove 65. The slide frame 64 slides together with the piezoelectric vibrator 61. Two lower ends of the slide 64 contact the outer surface of the rail 63 so as to prevent the rotation round the axis of the piezoelectric vibrator 61 in the groove 65. A workpiece can be placed on the upper surface of the slide frame 64 and the slide frame 64 or the piezoelectric vibrator 61 may be used as the action element. This embodiment is particularly suitable for industrial applications such as work moving apparatus in FMS and various driving sources in automatic machines (industrial robot).

The piezoelectric vibrator 61 used in the embodiment of Figure 24 is the one shown in Figures 25-27 which is 10mm in diameter and 10mm in length, and is polarized in the axial direction. The resonance frequency, Qm and admittance of the piezoelectric vibrator 1 are 127.7kHz, 211 and 0.64 ms, respectively. As can be seen from Figures 24 and 27, the axial vibration displacement is at a maximum on the contact portion (slide surface 60d) of the piezoelectric vibrator 1 with the rail 63. The direction of the vibration displacement may be reversed by the switch 73 and the moving direction of the piezoelectric vibrator 61 may arbitrarily be selectable by appropriately setting the switch 73.

Figure 28 is a graph showing the relationship between the applied voltage and the moving speed of the piezoelectric vibrator with the weight parameters m=0g and m=50g of the object placed on the slide frame 64. The moving speed 20cm/sec has been obtained with m=0 when the ac voltage of 50V is applied.

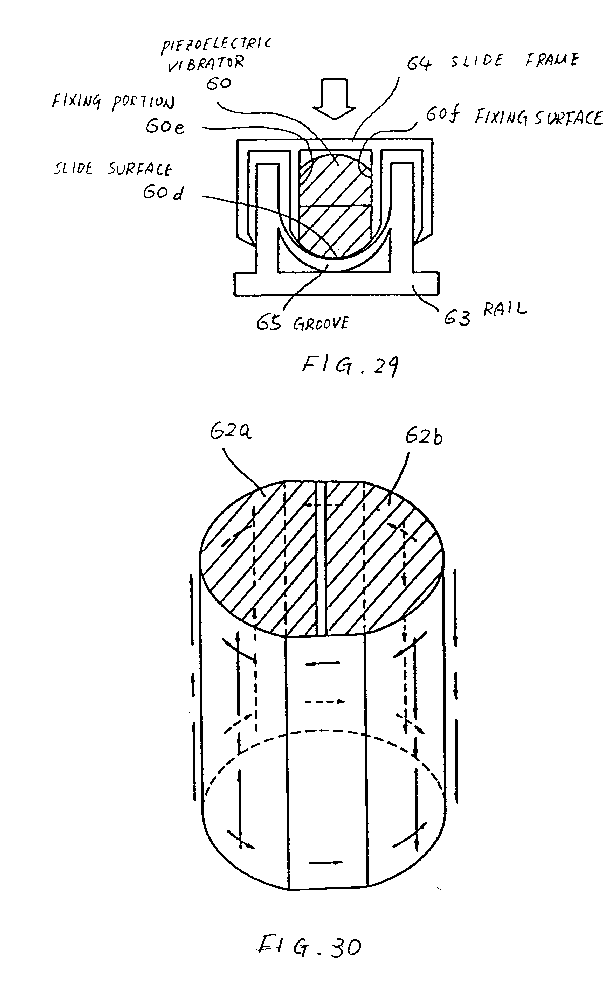

Figure 29 is a sectional side view of another embodiment of the present invention. Figure 30 illustrates the vibration displacement appearing on the piezoelectric vibrator of the embodiment in Figure 29. The difference between the embodiment in Figure 29 and that shown in Figure 24 is in the fixing structure between the piezoelectric vibrator and the slide frame. In the embodiment shown in Figure 29, the piezoelectric vibrator has the modified cylindrical shape in which both sides are flattened. On the both sides of the cylindrical piezoelectric vibrator there are produced the minimum vibration displacement. These flat sides are fixed to the slide frame 64. As can be seen from Figure 30, the modified cylindrical shape piezoelectric vibrator has essentially the same vibration displacement as that of the cylindrical piezoelectric vibrator.

By employing the structure shown in Figure 29 for fixing the piezoelectric vibrator, the influence of the fixing on the vibration displacement distribution becomes small and it is possible to easily and reliably fix the piezoelectric vibrator to the slide.

The following advantages can be obtained with the embodiments shown in Figures 24 and 29. The number of parts is small. The piezoelectric vibrator is extremely small but is capable of producing a large torque. The moving direction may be controlled by a simple driving circuit using a switch and a single-phase AC power source. Linear or curved movement is made possible by means of the rail.

Although in the above described embodiment the alternating voltage is supplied from an external power source, the piezoelectric vibrator may be driven by a battery and an oscillator on the piezoelectric vibrator. By placing the power source (battery) and the switch on the piezoelectric vibrator, the need for a flexible wire is eliminated. The switch may be controlled by an electromagnetic wave, thereby eliminating any limit on the moving range of the piezoelectric vibrator which arises due to the length of the wire.

## Claims

1. A vibration type actuator comprising a piezoelectric body (1), and a moving element (3) in contact with the piezoelectric body to be moved thereby upon energisation thereof, the piezoelectric body being pillar shaped having opposed base surfaces with electrodes (1b, 1c) thereon to receive a voltage for energising the body, and the moving element (3) contacting the piezoelectric body (1) at a predetermined side surface portion thereof in such a manner that the generated driving force is directed parallel to the longitudinal axis of the body (1).

2. An actuator according to claim 1 characterised in that said piezoelectric body (1) is cylindrical in shape.

3. An actuator according to claim 1 characterised in that a part of said side surface of said piezoelectric body (1) is a plane surface extending in the longitudinal direction thereof.

4. An actuator according to any preceding claim characterised by a drive circuit (12) connected to said electrodes for energising the piezoelectric body (1).

5. An actuator according to any preceding claim characterised in that a second said piezoelectric body (2) is arranged to cooperate with and drive the moving element (3).

6. An actuator according to any preceding claim characterised in that said moving element (3) is a rotary disk.

7. An actuator according to claim 5 characterised in that the moving element comprises a roller (31) in contact with the side surface of the piezoelectric body (11) in the longitudinal direction and rotated circumferentially due to the driving of said piezoelectric vibrator; supporting means (41) maintaining the distance between the rotational axis of said roller (31) and the piezoelectric body (11) to provide a stable contact pressure between said roller and the piezoelectric vibrator (11); and a pressing means (33,37) for pressing the roller (31) against a piece of paper (45).

8. An actuator according to any one of claims 1 to 5 characterised in that the piezoelectric body comprises a square pillar (51) with opposed ends (52,53) with electrodes (52,53a) thereon, the moving element (55) contacting the body at a predetermined contact pressure and on a side surface portion which is normal to the electrodes (52,53a).

9. Apparatus according to any one of claims 1 to 5 characterised in that the moving element (61,64) is guided by a rail (63).

10. An actuator according to any preceding claim characterised in that at least one of said electrodes (1b,1c) is electrically separated into two electrodes (1b_{A}, 1b_{B}).

11. An actuator according to any preceding claim characterised in that the pillar shape piezoelectric body (1) is polarized.

12. An actuator according to any preceding claim characterised in that at least one of the electrodes is formed on a part of one base surface.

## Patentansprüche

1. Antriebsanordnung vom Schwingungstyp, mit einem piezoelektrischen Körper (1) und einem beweglichen Element (3), das mit dem piezoelektrischen Körper in Berührung steht und durch diesen bei dessen Erregung bewegt wird, wobei der piezoelektrische Körper säulenförmig ist und gegenüberliegende Basisflächen aufweist, auf denen sich Elektroden (1b, 1b) zum Einleiten einer Spannung zur Erregung des Körpers befinden, und das bewegliche Element (3) den piezoelektrischen Körper (1) an einem vorbestimmten Abschnitt seiner Seitenfläche derart berührt, daß die erzeugte Antriebskraft parallel zur Längsachse des Körpers (1) gerichtet ist.

2. Antriebsanordnung nach Anspruch 1, dadurch gekennzeichnet, daß der piezoelektrische Körper (1) eine zylindrische Form aufweist.

3. Antriebsanordnung nach Anspruch 1, dadurch gekennzeichnet, daß ein Teil der Seitenfläche des piezoelektrischen Körpers (1) eine ebene Fläche ist, die sich in dessen Längsrichtung erstreckt.

4. Antriebsanordnung nach irgendeinem der vorhergehenden Ansprüche, gekennzeichnet durch einen Antriebsstromkreis (12), welcher an die Elektroden angeschlossen ist, um den piezoelektrischen Körper (1) zu erregen.

5. Antriebsanordnung nach irgendeinem der vorhergehenden Ansprüche, dadurch gekennzeichnet, daß ein zweiter piezoelektrischer Körper (2) angeordnet ist, um mit dem beweglichen Element (3) zusammenzuwirken und es anzutreiben.

6. Antriebsanordnung nach irgendeinem der vorhergehenden Ansprüche, dadurch gekennzeichnet, daß das bewegliche Element (3) eine rotierende Scheibe ist.

7. Antriebsanordnung nach Anspruch 5, dadurch gekennzeichnet, daß das bewegliche Element eine Walze (31), die mit der Seitenfläche des piezoelektrischen Körpers (11) in Längsrichtung in Berührung steht und umfangsmäßig infolge des Antriebes durch den piezoelektrischen Vibrator gedreht wird, Stützmittel (41), welche den Abstand zwischen der Drehachse der Walze (31) und dem piezoelektrischen Körper (11) halten, um einen unveränderlichen Berührungsdruck zwischen dieser Walze und dem piezoelektrischen Vibrator (11) zu gewährleisten, sowie Druckmittel (33, 37) zum Anrücken der Walze (31) gegen ein Stück Papier (45) umfaßt.

8. Antriebsanordnung nach irgendeinem der Ansprüche 1 bis 5, dadurch gekennzeichnet, daß der piezoelektrische Körper eine rechteckige Säule (51) mit gegenüberliegenden Enden (52, 53) umfaßt, auf denen sich Elektroden (52, 53a) befinden, wobei das bewegliche Element (55) den Körper mit einem vorbestimmten Berührungsdruck und auf einem Seitenflächenabschnitt, welcher senkrecht zu den Elektroden (52, 53a) ist, berührt.

9. Vorrichtung nach irgendeinem der Ansprüche 1 bis 5, dadurch gekennzeichnet, daß das bewegliche Element (61, 64) von einer Schiene (63) geführt wird.

10. Antriebsanordnung nach irgendeinem der vorhergehenden Ansprüche, dadurch gekennzeichnet, daß wenigstens eine der Elektroden (1b, 1c) elektrisch in zwei Elektroden (1b_{A}, 1b_{B}) unterteilt ist.

11. Antriebsanordnung nach irgendeinem der vorhergehenden Ansprüche, dadurch gekennzeichnet, daß der säulenförmige piezoelektrische Körper (1) polarisiert ist.

12. Antriebsanordnung nach irgendeinem der vorhergehenden Ansprüche, dadurch gekennzeichnet, daß wenigstens eine der Elektroden auf einem Teil einer Basisfläche ausgebildet ist.

## Revendications

1. Actionneur du type à vibration comportant un corps (1) piézo-électrique, un élément mobile (3) en contact avec le corps piézo-électrique et dont le mouvement est réalisé par excitation due à ce dernier, ledit corps piézo-électrique étant en forme de pilier comportant deux surfaces bases opposées munies d'électrodes (1b, 1c) destinées à être mises sous tension pour exciter le corps, et l'élément mobile (3) entrant en contact avec ledit corps (1) sur une portion de surface latérale prédéterminée du corps, de telle sorte que la force d'entraînement générée soit dirigée parallèlement à l'axe longitudinal de celui-ci (1).

2. Actionneur selon la revendication 1, caractérisé en ce que le corps piézo-électrique (1) est de forme cylindrique.

3. Actionneur selon la revendication 1, caractérisé en ce que la portion de ladite surface latérale du corps piézo-électrique (1) est une surface plane s'étendant longitudinalement à celui-ci.

4. Actionneur selon l'une quelconque des revendications précédentes, caractérisé par un circuit de commande (12) connecté à ces électrodes pour exciter le corps piézo-électrique.

5. Actionneur selon l'une quelconque des revendications précédentes, caractérisé en ce qu'un second corps piézo-électrique (2) est disposé de manière à coopérer avec l'élément mobile (3) et à l'entraîner.

6. Actionneur selon l'une quelconque des revendications précédentes, caractérisé en ce que ledit élément mobile (3) est un disque rotatif.

7. Actionneur selon la revendication 5, caractérisé en ce que l'élément mobile comprend un galet (31) en contact avec la surface latérale du corps piézo-électrique (1), selon une direction longitudinale, et en rotation par entraînement dû aux vibrations piézo-électriques ; des moyens support (41) destinés à maintenir la distance entre l'axe de rotation dudit galet (31) et le corps piézo-électrique (11), et pour assurer une pression de contact stable entre les deux ; et des moyens d'exercer une pression (33, 37) pour que le galet (31) soit en pression sur une feuille de papier (45).

8. Actionneur selon l'une quelconque des revendications 1 à 5, caractérisé en ce que le corps piézo-électrique comprend un pilier carré (51) avec des extrémités opposées (52, 53) dotées d'électrodes (52, 53a), l'élément mobile (55) étant en contact avec le corps à une pression de contact prédéterminée sur une portion de surface latérale normale aux électrodes (52, 53a).

9. Appareillage selon l'une quelconque des revendications 1 à 5, caractérisé en ce que l'élément mobile (61, 64) est guidé par un rail (63).

10. Actionneur selon l'une quelconque des revendications précédentes, caractérisé en ce qu'au moins une desdites électrodes (1b, 1c) est électriquement divisée en deux électrodes (1b_{A}, 1b_{B}).

11. Actionneur selon l'une quelconque des revendications précédentes, caractérisé en ce que le corps piézo-électrique (1) en forme de pilier est polarisé.

12. Actionneur selon l'une quelconque des revendications précédentes, caractérisé en ce qu'au moins une des électrodes est formée d'une partie d'une des surfaces des bases.
